# EUROPEAN PATENT APPLICATION

(11) **EP 4 718 978 A1**
(43) Date of publication of application: **01.04.2026**
(21) Application number: 25202827.9
(22) Date of filing: 17.09.2025
(51) Int. Cl.: H10D 30/01, H10D 30/00, H10D 64/01, H10D 84/01, H10D 84/03, H10D 84/83, B82Y 10/00

(54) **SELECTIVE NANORIBBON REMOVAL AND THINNING FOR WIDE RIBBON-TO-RIBBON SPACED TRANSISTORS**

(30) Priority: 27.09.2024 US 202418900346
(71) Applicant: Intel Corporation, Santa Clara, CA 95054 (US)
(72) Inventor: LEE, Chen-Guan, Portland, 97229 (US); RAMASWAMY, Rahul, Portland, 97229 (US); CHANG, Hsu-Yu, Hillsboro, 97124 (US); JAN, Chia-Hong, Portland, 97229 (US)
(74) Representative: 2SPL Patentanwälte PartG mbB

(57) **Abstract**

Devices, transistor structures, systems, and techniques are described herein related to gate all around field effect transistors having nanoribbons selectively removed to allow for thicker gate dielectric materials. In forming an alternating stack of semiconductor and sacrificial layers, a cladding layer is applied to those semiconductor layers to be removed during nanoribbon release. Prior to nanoribbon release, atoms of the cladding layer are diffused into only those semiconductor layers having the cladding. During nanoribbon release etch, the sacrificial layers and those semiconductor layers having diffused atoms therein are removed while the semiconductor layers without cladding remain. By removing nanoribbons, an increased ribbon-to-ribbon spacing is attained for application of thicker gate dielectric materials in gate all around field effect transistors.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanoribbon transistors are being deployed. In such devices, the gate structure, which includes a gate dielectric and a gate electrode, surrounds the channel region on all sides of each nanoribbon or nanowire of semiconductor material for improved drive current, device control, and other advantages. The nanoribbons are contacted on opposite sides by source and drain structures, which may be epitaxially grown materials.

Currently, these transistors have difficulty with respect to narrow ribbon-to-ribbon spacing, particularly in applications where a thick gate dielectric is desired such as high voltage transistors. High voltage transistors are used in input/output (I/O) circuitry and other circuits of an IC die, and the high voltage transistors require high turn on voltages and need to withstand high break down voltages. However, narrow ribbon-ribbon spacing in ribbon field effect transistor (FET) architecture poses limitations for applications requiring thick-gate dielectric deposition and/or needing the freedom to use work-function metal thickness for threshold voltage tunning. Existing techniques for increasing ribbon-to-ribbon spacing include increasing the space between the semiconductor (e.g., silicon) layers in the interleaved semiconductor and sacrificial material (e.g., silicon germanium) stacks (i.e., increasing the sacrificial material layer thickness) during superlattice formation and trimming the thickness of the semiconductor layers after nanoribbon release (i.e., after removing the sacrificial material layers). However, increasing the space between the semiconductor layers disadvantageously increases capacitance and degrades transistor performance and trimming the thickness of the semiconductor layers, particularly in thick gate dielectric applications that use longer nanoribbon lengths, causes physical bending and failure of the nanoribbons leading to reduced yield and transistor performance.

It is with respect to these and other considerations that the present improvements have been needed. Such improvements may become critical as the desire to deploy multi-gate transistor structures such as ribbon field effect transistors becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG.1 is a flow diagram illustrating exemplary methods for forming integrated circuit structures with thin gate dielectric gate-all-around transistors integrated with thick gate dielectric gate-all-around transistors enabled by nanoribbon removal;
FIGS. 2, 3, 4, 5, 6, 7, 8, 9, 10, 11, 12, 13, 14, and 15 are cross-sectional side views of example integrated circuit structures as particular fabrication operations of the methods of FIG. 1 are performed;
FIG. 16 is a cross-sectional side view of a multi-layer integrated circuit device structure incorporating the thin gate dielectric transistor structure and the thick gate dielectric transistor structure of the integrated circuit structure of FIG. 15;
FIG. 17 illustrates exemplary systems employing an integrated circuit assembly including an integrated circuit die having a thin gate dielectric transistor structure integrated with a thick gate dielectric transistor structure; and
FIG. 18 is a functional block diagram of an electronic computing device, all in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to selectively removing nanoribbons of gate-all-around field effect transistors (GAA-FETs) using a cladding and diffusion to modify those semiconductor materials to be removed prior to nanoribbon release.

As discussed, multi-gate transistors such as gate-all-around (GAA) or nanoribbon transistors are being deployed in advanced integrated circuit devices. As used herein, the terms nanowire, nanoribbon, stacked semiconductor structure, and similar terms are used substantially interchangeably to indicate a semiconductor material that extends from a source to a drain such that the semiconductor material is wrapped around by the gate structure. If multiple such semiconductor materials are used, they are separated by the gate structure and vertically aligned. The one or more semiconductor material structures each couple to the same source and drain, and are vertically separated by the gate structure, which includes a gate dielectric and a gate electrode.

Thereby, the field effect transistor or device includes a source, a drain, and one or a stack of semiconductor structures extending between the source and the drain. The source and drain are epitaxial to the semiconductor structures. As used herein the term epitaxial to or similar terms indicate the materials are substantially lattice matched. The stack of semiconductor structures (e.g., one to about eight semiconductor structures) are controlled by the same gate electrode, and work in concert as the channel of the device. As used herein, the term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms.

Current GAA-FETs have difficulties with respect to narrow ribbon-to-ribbon spacing, particularly in applications where a thick gate dielectric is desired, such as high voltage transistors. High voltage transistors are used in input/output (I/O) circuitry such as power regulation and in other circuits of an IC die. High voltage transistors require high turn on voltages and need to withstand high break down voltages. However, narrow ribbon-ribbon spacing in ribbon field effect transistor (FET) architecture poses limitations for applications requiring thick-gate dielectric deposition and/or needing the freedom to use work-function metal thickness for threshold voltage tunning. In some embodiments, relatively thick gate dielectric GAA-FETs are fabricated by selectively removing nanoribbons during nanoribbon release by diffusing atoms into the semiconductor material from a cladding. For example, a germanium cladding may be formed on those silicon semiconductor layers that are to be removed while silicon semiconductor layers that are to remain are absent the germanium. The cladded and non-cladded layers are interleaved with silicon germanium sacrificial layers that are removed during nanoribbon release.

In some embodiments, relatively thick gate dielectric layer transistors are integrated with relatively thin gate dielectric layer transistors. As used herein, the terms relatively thick and relatively thin or similarly thick and thin are made relative to other similar features across the transistors. In some embodiments, the thick layer is not less than 50% thicker than the thin layer, not less than twice the thickness of the thin layer, not less than three times the thickness of the thin layer, or the like. Furthermore, the thick gate dielectric layer is enabled by nanoribbon removal and therefore the thick gate dielectric layer transistors have fewer nanoribbons than the thin gate dielectric layer transistors. Notably, each of the nanoribbons of the thick gate dielectric layer transistors are co-planar with a nanoribbon of the thin gate dielectric layer transistors. However, some of the nanoribbons of the thin gate dielectric layer transistors have no co-planar nanoribbons in the thick gate dielectric layer transistors due to their removal during nanoribbon release.

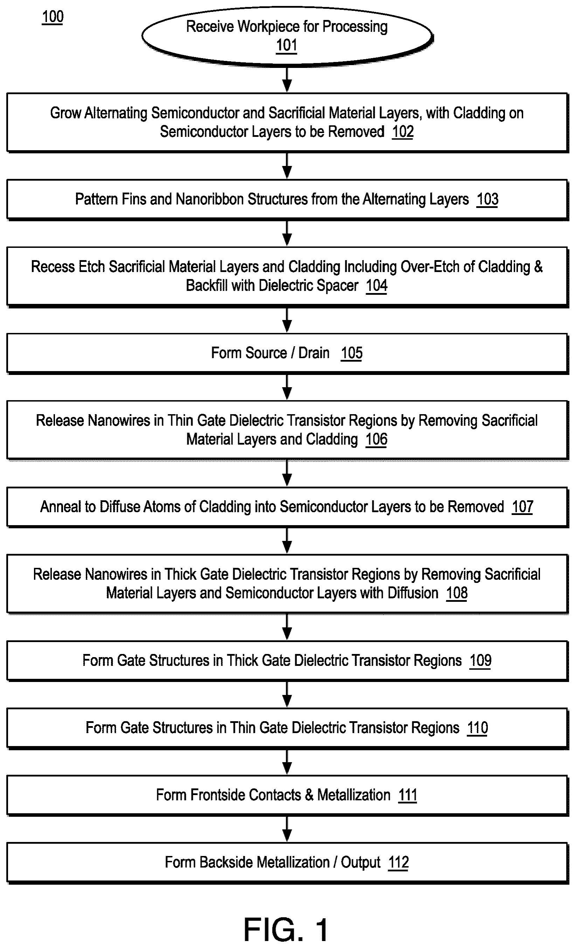

FIG. 1 is a flow diagram illustrating exemplary methods 100 for forming integrated circuit structures with thin gate dielectric gate-all-around transistors integrated with thick gate dielectric gate-all-around transistors enabled by nanoribbon removal, arranged in accordance with at least some implementations of the present disclosure. For example, methods 100 may be implemented to fabricate integrated circuit (IC) structures 1400, 1500, multi-layer IC device structure 1600 or any other transistor or IC structures discussed herein. In the illustrated implementation, methods 100 may include one or more operations as illustrated by operations 101-112. However, embodiments herein may include additional operations, certain operations being omitted, or operations being performed out of the order provided.

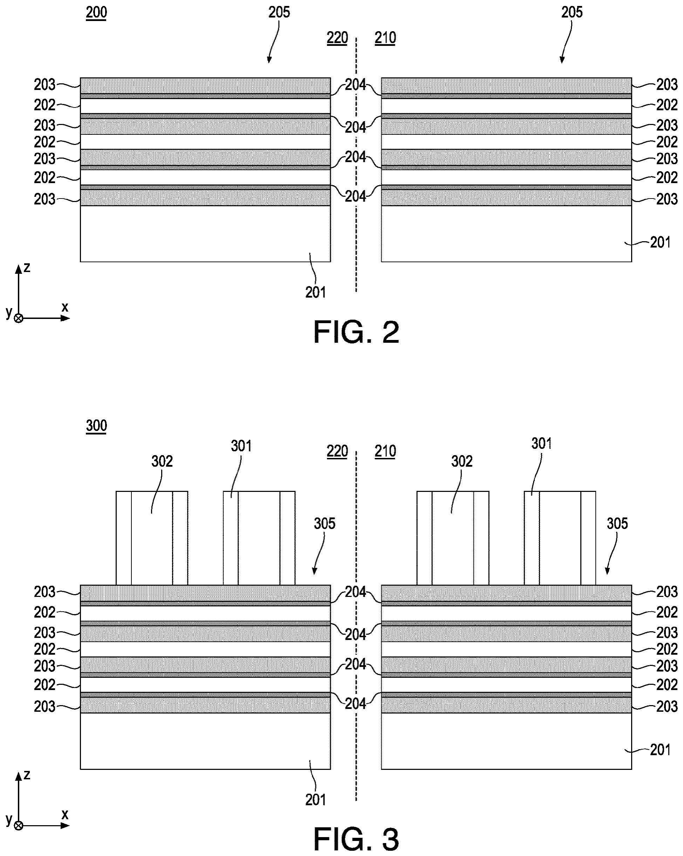

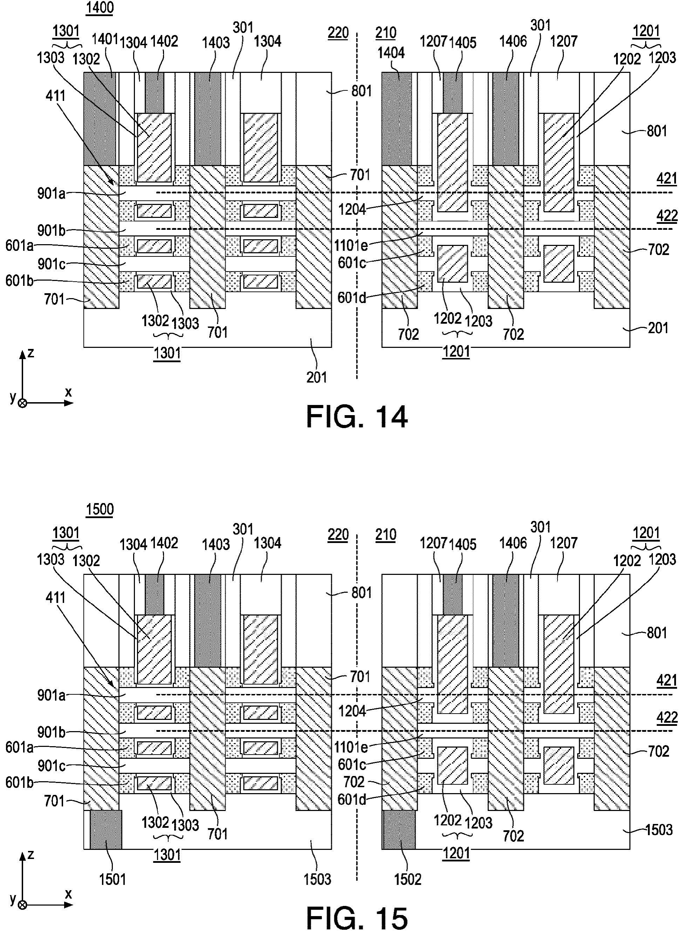

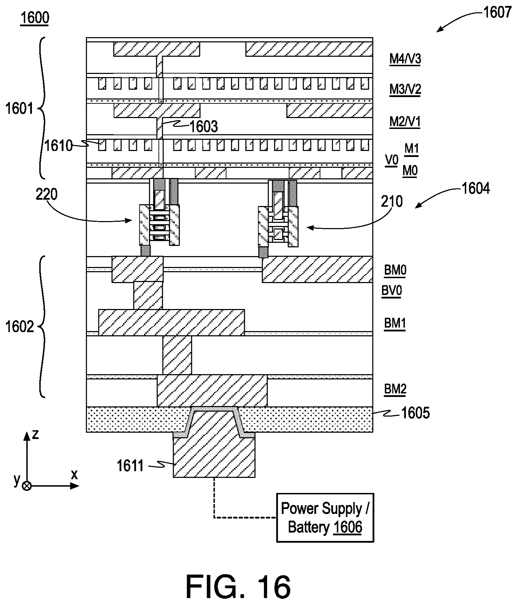

FIGS. 2, 3, 4, 5, 6, 7, 8, 9, 10, 11, 12, 13, 14, and 15 are cross-sectional side views of example integrated circuit structures as particular fabrication operations of methods 100 are performed, arranged in accordance with at least some implementations of the present disclosure. FIG. 16 is a cross-sectional side view of the integrated circuit structure of FIG. 15 incorporated in a multi-layer integrated circuit device structure. Although illustrated with respect to the integrated circuit structure of FIG. 15, any transistor structure discussed herein may be deployed in the context of the multi-layer integrated circuit device structure of FIG. 16.

Processing begins at operation 101, where a workpiece such as a substrate is received for processing. The substrate may include any suitable substrate as discussed herein such as a silicon wafer or the like. In some embodiments, the substrate includes underlying devices or electrical interconnects. Processing continues at operation 102, where alternating layers of semiconductor material layers and sacrificial layers are formed over the workpiece or substrate such that a cladding is applied to those semiconductor material layers that are to be selectively removed later in processing.

For example, the techniques discussed herein may use the high germanium (Ge) to silicon (Si) etch selectivity in nanoribbon or nanowire release. At superlattice deposition, high or higher germanium concentration cladding layers are deposited on those silicon semiconductor material layers that are to be removed. By controlling the sequence of nanoribbon or nanowire release and germanium diffusion anneal, silicon nanoribbon or nanowire can be selectively controlled. Such techniques provide flexibility in controlling the space in between Si nanoribbon. In the same integrated flow, transistor structures or devices with different ribbon space are fabricated, which opens possibility for thick-gate device applications and using work-function metal thickness for threshold voltage tuning.

FIG. 2 is a cross-sectional side view of an example IC structure 200 after growth of an interleaved stack 205 of alternating semiconductor material layers 202 and sacrificial material layers 203, with selected ones of semiconductor material layers 202 having a cladding layer 204 on each side thereof, over a substrate 201. Substrate 201 may include any suitable material or materials and, in some embodiments, substrate 201 includes a material or materials having the same or a similar composition with respect to semiconductor material layers 202. In some embodiments, substrate 201 and semiconductor material layers 202 include a Group IV material (e.g., silicon). In some embodiments, substrate 201 and semiconductor material layers 202 include a substantially monocrystalline material. In some embodiments, substrate 201 includes a buried insulator layer (e.g., SiO₂), for example, of a semiconductor-on-insulator (SOI) substrate and/or isolation insulator regions and the like.

A thin gate dielectric transistor structure 220 is fabricated in a first region of substrate 201 and a thick gate dielectric transistor structure 210 is fabricated in a second region of substrate 201. Thin gate dielectric transistor structure 220 and thick gate dielectric transistor structure 210 are integrated into an IC die, for example. In addition to having differences in dielectric material thicknesses, thin gate dielectric transistor structure 220 has more nanoribbons than thick gate dielectric transistor structure 210 due to removal of those nanoribbons coated by cladding layers 204, as discussed further herein. Furthermore, different dielectric materials and/or electrode materials may be used.

Semiconductor material layers 202 may include any number of layers for the formation of semiconductor structures, channel semiconductors, nanoribbons, or nanowires over substrate 201 such as three, four, five, six, seven, eight or more layers with even numbers of semiconductor material layers 202 typically being deployed. Although illustrated with respect to three semiconductor material layers 202 with cladding layers 204 on each surface of two (top and bottom) of semiconductor material layers 202, any number of semiconductor material layers 202 and cladding combinations may be used. In some embodiments, every other one of semiconductor material layers 202 has cladding layers 204, for example. Therefore, the discussed processing may leave any number of remaining nanoribbons for thick gate dielectric transistor structure 210. In the illustrated example, a single nanoribbon remains. However, a plurality of nanoribbons (i.e., a stack of vertically aligned nanoribbons) may remain. In some embodiments, every other is removed such that thin gate dielectric transistor structure 220 has twice as many nanoribbons as thick gate dielectric transistor structure 210.

Semiconductor material layers 202 (with or without cladding layers 204) are separated by and interleaved with sacrificial material layers 203. Sacrificial material layers 203 and cladding layers 204 will be removed from thin gate dielectric transistor structure 220 during a first nanoribbon release. Furthermore, after anneal processing, sacrificial material layers 203, cladding layers 204, and those semiconductor material layers 202 with cladding layers 204 (due to diffusion into semiconductor material layers 202) are removed from thick gate dielectric transistor structure 210 during a subsequent nanoribbon release.

In some embodiments, semiconductor material layers 202 are substantially pure or pure silicon such as substantially pure or pure monocrystalline silicon, sacrificial material layers 203 are silicon germanium such as monocrystalline silicon germanium, and cladding layers 204 are substantially pure or pure germanium such as substantially pure or pure monocrystalline germanium. However, other material systems may be used. Interleaved stack 205 may be formed using any suitable technique or techniques such as epitaxial growth techniques. Semiconductor material layers 202, sacrificial material layers 203, and cladding layers 204 may have any suitable thicknesses (i.e., measured in the z-dimension) such as thicknesses in the range of about 4 to 12 nm.

Returning to FIG. 1, processing continues at operation 103, where fins or fin structures are patterned from the interleaved stack formed at operation 102 and then nanoribbon structures are patterned from the fins. The fins or fin structures may be patterned using any suitable technique or techniques. In some embodiments, a mask structure is formed using lithography etch techniques such that the mask defines rows of fins or fin structures, and a subsequent etch forms the fins or fin structures. Subsequently an orthogonal dummy gate and gate spacer may be patterned over the fins. An etch then forms nanoribbon or channel structures from the fins.

FIG. 3 is a cross-sectional side view of an example IC structure 300 similar to IC structure 200, after patterning fins 305 from interleaved stack 205 and after formation of dummy gate structure 302 and spacers 301. In some embodiments, interleaved stack 205 is first etched to define fins extending in the x-dimension using lithography and etch techniques. Dummy gate structures 302, which extend in the y-dimension, may then be formed and patterned (i.e., by bulk deposition and patterning using lithography and etch), and spacers 301 may then be formed using conformal deposition and anisotropic etch. Dummy gate structures 302 may be any suitable material such as polysilicon. Spacers 301 may be any suitable dielectric material such as silicon oxide, silicon nitride, silicon oxynitride, or the like.

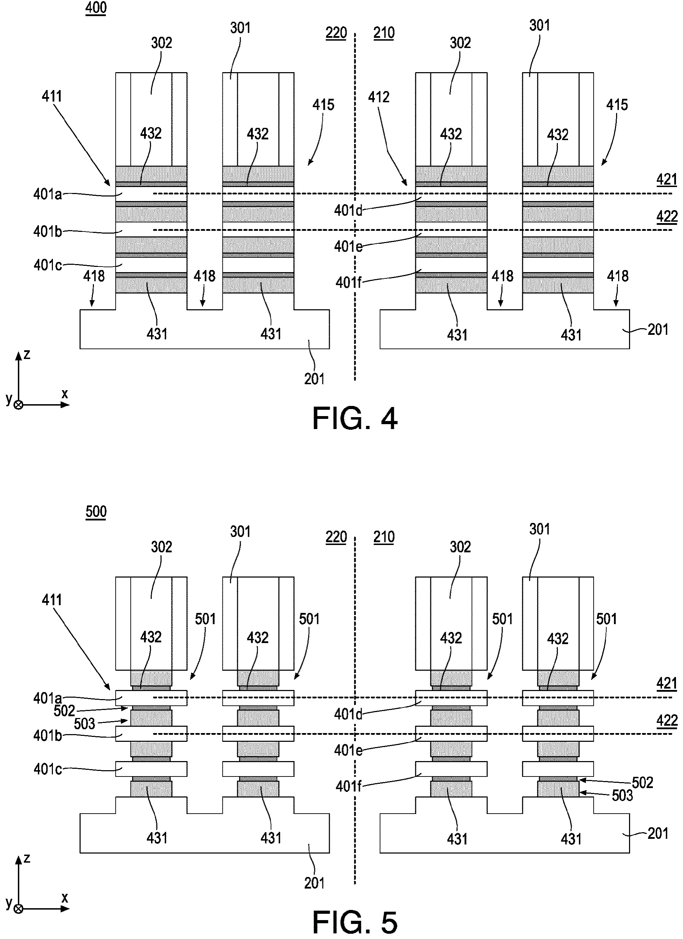

FIG. 4 is a cross-sectional side view of an example IC structure 400 similar to IC structure 300, after etching down fins 305 to form patterned stacks 415 inclusive of patterned semiconductor layers 401a-f, patterned sacrificial layers 431, and patterned cladding layers 432. As discussed below, all of patterned semiconductor layers 401a, 401b, 40c will be released to form a stack of vertically aligned semiconductor structures 411 for thin gate dielectric transistor structure 220. However, only some of a stack of vertically aligned semiconductor structures 412 will be released to form one nanoribbon or a stack of vertically aligned nanoribbons for thick gate dielectric transistor structure 210. Also as shown, individual semiconductor structures of stack of vertically aligned semiconductor structures 411 and stack of vertically aligned semiconductor structures 412 are co-planar, as shown with respect to exemplary planes 421 422. For example, patterned semiconductor layers 401a, 401d are co-planar across plane 421, patterned semiconductor layers 401b, 401e are co-planar across plane 422, patterned semiconductor layers 401c, 401f are co-planar across an unlabeled plane, and so on. As used herein, co-planar indicates at least a portion of each of the components are aligned in the same plane. In some embodiments, the centerline of each of patterned semiconductor layers 401a, 401d, patterned semiconductor layers 401b, 401e, and so on are co-planar. In some embodiments, recesses 418 are etched in substrate 201 during the etch of fins 305.

Returning to FIG. 1, processing continues at operation 104, where a recess etch is performed to recess the sacrificial material and the cladding material. The recess is then backfilled to form a spacer of dielectric material. The recess etch may be performed using any suitable technique or techniques such as a selective etch selective to the germanium content of the sacrificial material and the cladding material relative to the pure silicon content of the semiconductor layers. The spacer of dielectric material may then be formed using any suitable technique or techniques such as material deposition followed by anisotropic etch. The spacer may be any suitable dielectric material such as silicon oxide, silicon nitride, or silicon oxynitride with silicon oxynitride being particularly advantageous. For example, the spacer may include silicon, oxygen, and nitrogen.

FIG. 5 is a cross-sectional side view of an example IC structure 500 similar to IC structure 400, after recess etching 501 portions of patterned sacrificial layers 431 and patterned cladding layers 432. As shown, due to etch selectivity, patterned cladding layers 432, which have high or pure germanium content, are more rapidly etched than patterned sacrificial layers 431. This is evident in recess 502 of patterned cladding layers 432 being deeper than recess 503 of patterned sacrificial layers 431. As discussed further herein below, the resultant dielectric spacer on and adjacent to patterned sacrificial layers 431 and patterned cladding layers 432 therefore has a greater width on those patterned semiconductor layers 401a, 401c, 401d, 401f that have cladding relative to those patterned semiconductor layers 401b, 401e that did not.

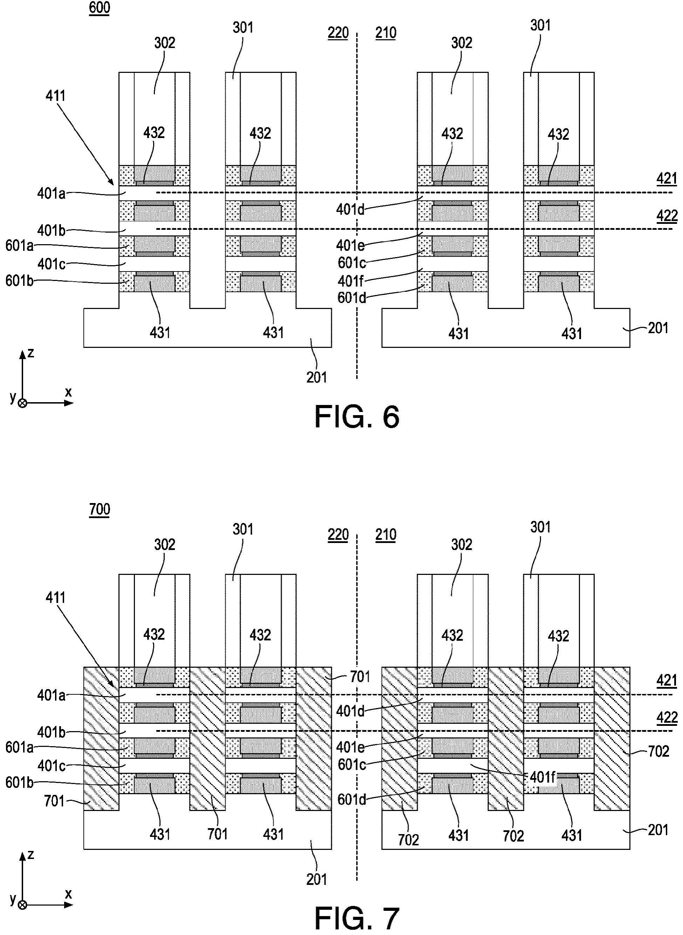

FIG. 6 is a cross-sectional side view of an example IC structure 600 similar to IC structure 500, after forming dielectric spacers 601 in the recessed regions. Dielectric spacers 601 may then be formed using material deposition and anisotropic etch techniques, and dielectric spacers 601 may be any suitable dielectric material such as silicon oxide (i.e., including silicon and oxygen), silicon nitride (i.e., including silicon and nitrogen), or silicon oxynitride (i.e., including silicon, oxygen, and nitrogen). As shown, dielectric spacers 601a, 601b, 601c, 601d each have a cross-sectional shape with a greater width on and adjacent those patterned semiconductor layers 401a, 401c, 401d, 401f with patterned cladding layers 432 and a lesser width on those patterned semiconductor layers 401b, 401e absent a cladding. In some embodiments, the greater width is not less than 10% greater than the lesser width, not less not less than 20% greater, not less than 25% greater, not less than 40% greater, or more.

Returning to FIG. 1, processing continues at operation 105, where epitaxial source and drain materials are grown or deposited via the exposed ends of the interleaved semiconductor material layers. In some embodiments, an epitaxial nucleation layer may be deposited, followed by bulk deposition. In some embodiments, the epitaxial nucleation layer and bulk epitaxial materials are deposited in the same process chamber using differing deposition parameters. The source and drain materials may be any suitable materials such as doped silicon, doped silicon germanium, or the like. The epitaxial source and drain materials may be deposited using any suitable technique or techniques such as chemical vapor deposition (CVD) including is situ deposition of dopant materials.

FIG. 7 is a cross-sectional side view of an example IC structure 700 similar to IC structure 600, after the epitaxial growth of source and drain structures 701, 702. Source and drain structures 701, 702 may be a single material (as shown) or they may include an epitaxial nucleation layer and a bulk epitaxial material. Source and drain structures 701, 702 may be fabricated using CVD or other epitaxial deposition techniques. Source and drain structures 701, 702 are epitaxial to exposed ends of patterned semiconductor layers 401, and source and drain structures 701, 702 may be doped epitaxial silicon or doped epitaxial silicon and germanium (SiGe). In some embodiments, the dopant is boron or gallium for PMOS devices and phosphorous or arsenic for NMOS devices, although other suitable dopants may be used.

Returning to FIG. 1, processing continues at operation 106, where the sacrificial material layers and cladding are removed in the thin gate dielectric transistor regions using selective etch techniques such as wet etch techniques to release the nanoribbons or semiconductor structures. For example, etch selectivity between the silicon semiconductor materials and the silicon germanium sacrificial material layers and the germanium cladding layers the semiconductor material layers due to the differing materials deployed (i.e., with germanium containing or germanium rich materials being etched while pure or substantially pure silicon remains) is leveraged to release the nanoribbons. In some embodiments, the thick gate dielectric transistor regions are masked using a photoresist or other masking material during such processing. In some embodiments, the selective etch removes the sacrificial material layers and cladding to release a nanoribbon corresponding to each semiconductor material layer grown at operation 102 (i.e., those with or without cladding). The released nanoribbons are structurally supported by the source and drain structures formed at operation 105.

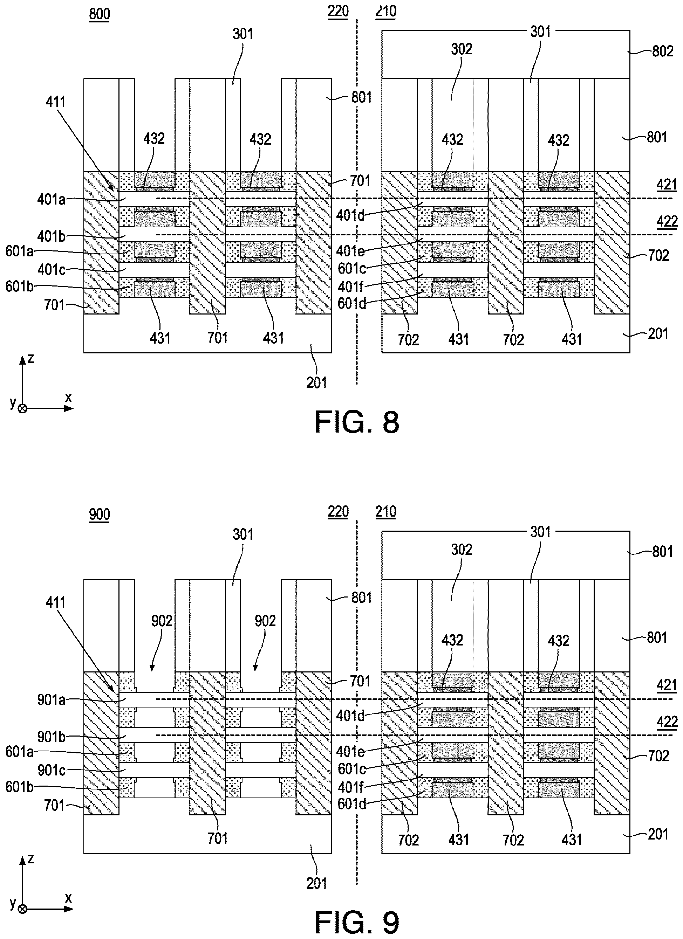

FIG. 8 is a cross-sectional side view of an example IC structure 800 similar to IC structure 700, after formation of a dielectric layer 801, patterning a mask layer 802, and removal of dummy gate structures 302 of thin gate dielectric transistor structure 220 to expose patterned sacrificial layers 431 and patterned cladding layers 432. Dielectric layer 801 may be formed using any suitable technique or techniques such as bulk layer deposition followed by planarization, and dielectric layer 801 may be any suitable dielectric material such as silicon oxide. Patterned mask layer 802 may be any suitable material that will block regions of thick gate dielectric transistor structure 210 during processing such as a photoresist, hard mask, or similar material. Dummy gate structures 302 of thin gate dielectric transistor structure 220 may then be removed using, for example, selective etch techniques.

FIG. 9 is a cross-sectional side view of an example IC structure 900 similar to IC structure 800, after removal of patterned sacrificial layers 431 and patterned cladding layers 432 of thin gate dielectric transistor structure 220 to form openings 902. Furthermore, such processing releases stack of vertically aligned semiconductor structures 411, which are anchored by source and drain structures 701 and dielectric spacers 601 such as dielectric spacers 601a, b. Patterned sacrificial layers 431 and patterned cladding layers 432 are removed using selective etch techniques. Notably, such etch processes are highly selective to germanium content and patterned sacrificial layers 431 (e.g., silicon germanium) and patterned cladding layers 432 (e.g., germanium) are removed while semiconductor structures 901 such as 901a, 901b, 901c remain and are released to be nanowires, nanoribbons, or semiconductor structures 901 of a resultant transistor device. For example, semiconductor structures 901 has the same number of semiconductor structures 901 as the number of layers of semiconductor material layers 202 formed at operation 102.

Returning to FIG. 1, processing continues at operation 107, where an anneal is performed to diffuse atoms (e.g., germanium atoms) from the cladding layers formed at operation 102 into the semiconductor layers on which the cladding layers were applied, only in the thick dielectric material transistor structures where the cladding remains. For example, the cladding layers in the thin dielectric material transistor structures were removed at operation 106, and the remaining cladding layers can be used to selectively remove semiconductor layers in the thick dielectric material transistor structures. The anneal processing may be performed using any suitable technique or techniques such as rapid thermal anneal processing at any suitable temperature and duration to diffuse germanium atoms into the semiconductor layers to a level necessary for their removal in subsequent etch processing.

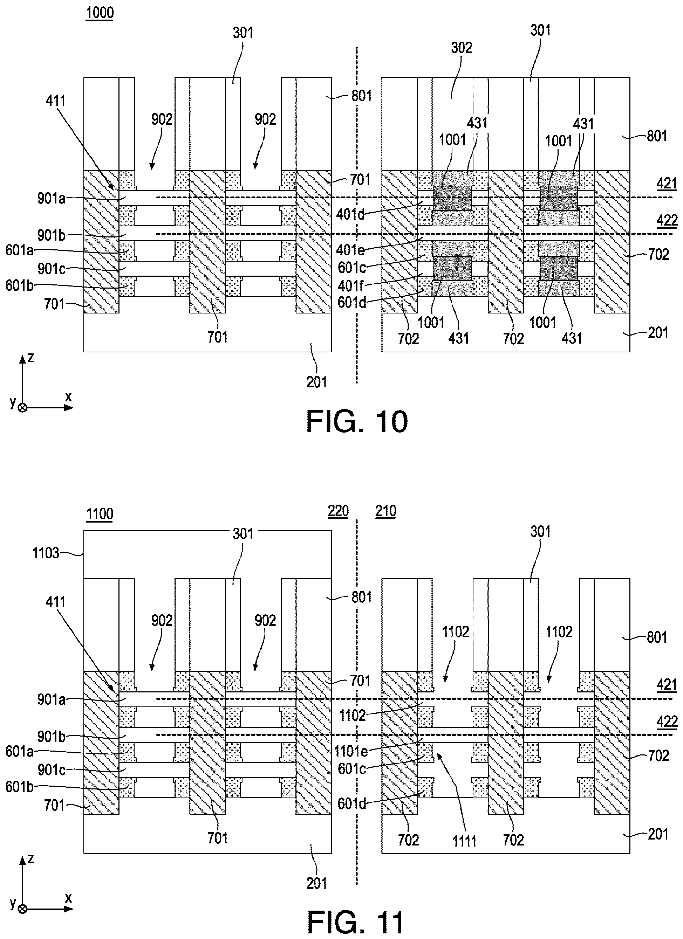

FIG. 10 is a cross-sectional side view of an example IC structure 1000 similar to IC structure 900, after diffusion from remaining patterned cladding layers 432 (see FIG. 9) into those patterned semiconductor layers such as patterned semiconductor layers 401d, 401f still having patterned cladding layers 432 thereon to form diffused material structures 1001, which are silicon germanium and will be removed by subsequent etch processing. As shown, in some embodiments, end portions of patterned semiconductor layers 401d, 401f do not include germanium diffusion and may remain after nanoribbon release. However, as shown in subsequent FIGS., in some embodiments the discussed diffusion processing forms diffused material structures 1001 throughout patterned semiconductor layers 401d, 401f and the entirety of patterned semiconductor layers 401d, 401f are removed during the selective etch processing of nanowire or nanoribbon release.

Returning to FIG. 1, processing continues at operation 108, where the sacrificial material layers and the diffusion regions (formed at operation 107) are removed in the thick gate dielectric transistor regions using selective etch techniques such as wet etch techniques to release the nanoribbons or semiconductor structures. In the context of operation 108, the etch selectivity between the silicon semiconductor materials and the silicon germanium sacrificial material layers and the silicon germanium diffusion regions of those semiconductor material layers having a cladding thereon is used to release the remining semiconductor structures not having germanium (e.g., substantially pure or pure silicon). In some embodiments, the thin gate dielectric transistor regions are masked using a photoresist or the like during such processing. In some embodiments, the selective etch removes the sacrificial material layers and previously cladded semiconductor structures to release a nanoribbon corresponding to each semiconductor material layer grown at operation 102 that are absent cladding.

FIG. 11 is a cross-sectional side view of an example IC structure 1100 similar to IC structure 1000, after patterning a mask layer 1103, removal of 302 of thick gate dielectric transistor structure 210, and removal of patterned sacrificial layers 431 and diffused material structures 1001 (including ends of the semiconductor layers, see FIG. 10) of thick gate dielectric transistor structure 210 to form openings 1102. Such processing releases one or more (i.e., a stack) of vertically aligned semiconductor structures 1111, which are anchored by source and drain structures 702 and dielectric spacers 601 such as dielectric spacers 601c, d. Although illustrated with respect to one semiconductor structure 1101e, stack of vertically aligned semiconductor structures 1111 may include any number of semiconductor structure 1101 such as two, three, four, or more. In some embodiments, stack of vertically aligned semiconductor structures 1111 has half as many semiconductor structures as stack of vertically aligned semiconductor structures 411.

Dummy gate structures 302 of thick gate dielectric transistor structure 210 may be removed using any suitable technique or techniques such as selective etch techniques. Patterned sacrificial layers 431 and diffused material structures 1001 are then removed using selective etch techniques. As discussed, such etch processes are highly selective to germanium content and patterned sacrificial layers 431 (e.g., silicon germanium) and diffused material structures 1001 (e.g., silicon germanium due to germanium diffusion) are removed while semiconductor structures 1101 such as 1101e remain are and are released to be nanowires, nanoribbons, or semiconductor structures 1101 of a resultant transistor device.

As discussed, the techniques herein leverage the high Ge-to-Si etch selectivity at nanowire or nanoribbon release such as dry etch processes with high etch rate to Ge and SiGe and very low etch rate to Si. Herein, extra layers with high Ge concentration are inserted next to the Si layers that are to be removed at nanowire or nanoribbon release. The Ge cladding layers are then used to diffuse Ge into the adjacent Si ribbons to make the ribbons easy to etch during nanowire or nanoribbon release processing. By controlling the sequence of the Ge diffusion anneal and the nanowire or nanoribbon release steps, control of removal of the Ge cladded Si ribbon or not may be leveraged to form transistors with different numbers of nanowires or nanoribbons and different gate dielectric thicknesses for different applications within the IC device.

Returning to FIG. 1, processing continues at operation 109, where a gate structure, including a relatively thick gate dielectric material on at least portions of the semiconductor structures (i.e., nanoribbons), and a gate electrode (e.g., gate metal) on the gate dielectric material are formed in the thick dielectric material transistor structures. The gate structure may be formed using any suitable technique or techniques. In some embodiments, the gate dielectric material is formed using conformal deposition processing, and the gate electrode is formed by conformal deposition of a work function metal followed by metal fill. However, other fabrication techniques may be used.

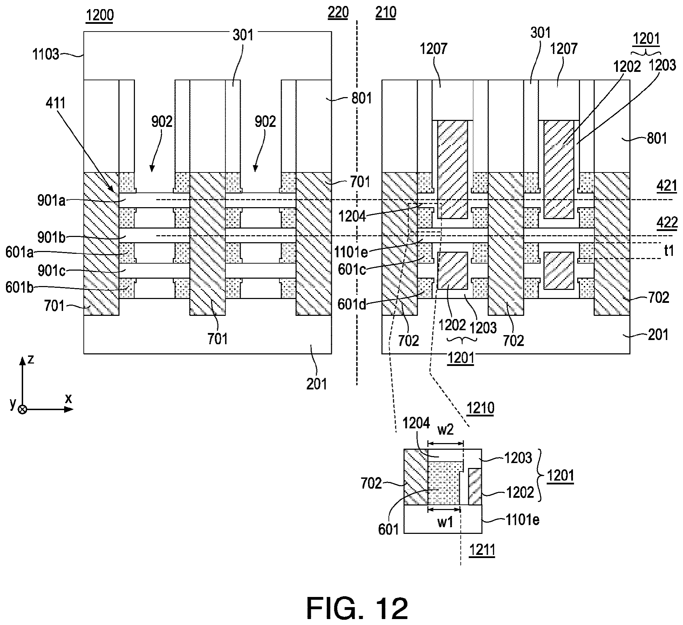

FIG. 12 is a cross-sectional side view of an example IC structure 1200 similar to IC structure 1100, after formation of gate structure 1201, which includes a gate dielectric layer 1203 and a gate electrode 1202. Gate structure 1201 may be formed by conformal deposition of gate dielectric layer 1203 followed by conformal deposition of a work function metal of gate electrode 1202 followed by metal fill of a remainder of gate electrode 1202. Formation of gate structure 1201 may include formation of a dielectric material 1207. As shown, in some embodiments, gate dielectric layer 1203 includes a portion 1204 that is on dielectric spacers 601 and extends to contact source and drain structures 702. This portion 1204 of gate dielectric layer 1203 is due to the etch out discussed with respect to FIG. 11.

In some embodiments, removal of semiconductor structures enables a thicker gate dielectric layer 1203 having a thickness t1 on semiconductor structures 1101 such as 1101e. In some embodiments, thickness t1 is not less than 3 nm. In some embodiments, thickness t1 is not less than 4 nm. In some embodiments, thickness t1 is not less than 5 nm. Other thickness may be used. In some embodiments, gate dielectric layer 1203 is or includes aluminum oxide, hafnium oxide, zirconium oxide, titanium silicon oxide, hafnium silicon oxide, silicon oxide, or silicon nitride. For example, gate dielectric layer 1203 may include aluminum and oxygen; hafnium and oxygen; zirconium and oxygen; titanium, silicon, and oxygen; hafnium, silicon, and oxygen; silicon and oxygen; or silicon and nitrogen. In some embodiments, gate electrode 1202 includes a work function layer of platinum, nickel, titanium nitride, or tantalum nitride and a fill metal such as tungsten. However, other material systems may be used.

In some embodiments, thick gate dielectric transistor structure 210, in addition to having a thicker gate dielectric layer 1203 and fewer semiconductor structures 1101 than thin gate dielectric transistor structure 220, utilizes a different gate dielectric layer 1203. In some embodiments, gate dielectric layer 1203 is silicon oxide (i.e., includes silicon and oxygen) and the gate dielectric layer of thin gate dielectric transistor structure 220 is other than silicon oxide such as a high-k gate dielectric material.

As shown, thick gate dielectric transistor structure 210 includes at least one semiconductor structure 1101e laterally between and coupled to source and drain structures 702. Gate structure 1201 includes gate dielectric layer 1203 (e.g., a gate dielectric) on and surrounding a channel region of semiconductor structure 1101e and gate electrode 1202 (e.g., a gate metal) surrounding gate dielectric layer 1203. Dielectric spacers 601 such as dielectric spacers 601c, d are laterally between and on gate structure 1201 and one or both of source and drain structures 702. As shown with respect to insert 1210, dielectric spacer 601 is on semiconductor structure 1101e adjacent channel region 1211 (i.e., the portion of on semiconductor structure 1101e adjacent to and controlled by gate structure 1201). Dielectric spacer 601 has a first width w1 and a second width w2 each extending between gate structure 1201 and source or drain structure 702 such that the first width w1 is adjacent semiconductor structure 1101e and the second width w2 is distal semiconductor structure 1101e and not less than ten percent greater than the first width w1. As discussed, second width w2 is greater than first width w1 due to the etch out of patterned cladding layers 432 (see FIG. 4). In some embodiments, second width w2 is not less than 20% greater than first width w1. In some embodiments, second width w2 is not less than 25% greater than first width w1. In some embodiments, second width w2 is not less than 50% greater than first width w1. First width w1 may be any suitable width such as not less than 1 nm, not less than 2 nm, not less than 5 nm, or the like.

Also as shown, portion 1204 of gate dielectric layer 1203 is on dielectric spacer 601and is in contact with source or drain structure 702. In some embodiments, dielectric spacer 601 is silicon oxynitride (i.e., includes silicon, oxygen, and nitrogen) and gate dielectric layer 1203 is silicon oxide (i.e., includes silicon and oxygen). However, gate dielectric layer 1203 may be any material discussed above.

Returning to FIG. 1, processing continues at operation 110, where a gate structure, including a relatively thin gate dielectric material on at least portions of the semiconductor structures (i.e., nanoribbons), and a gate electrode (e.g., gate metal) on the gate dielectric material are formed in the thin dielectric material transistor structures. In some embodiments, the gate dielectric material is formed using conformal deposition processing, and the gate electrode is formed by conformal deposition of a work function metal followed by metal fill. However, other fabrication techniques may be used. In some embodiments, the thick dielectric material transistor structures are masked during such processing.

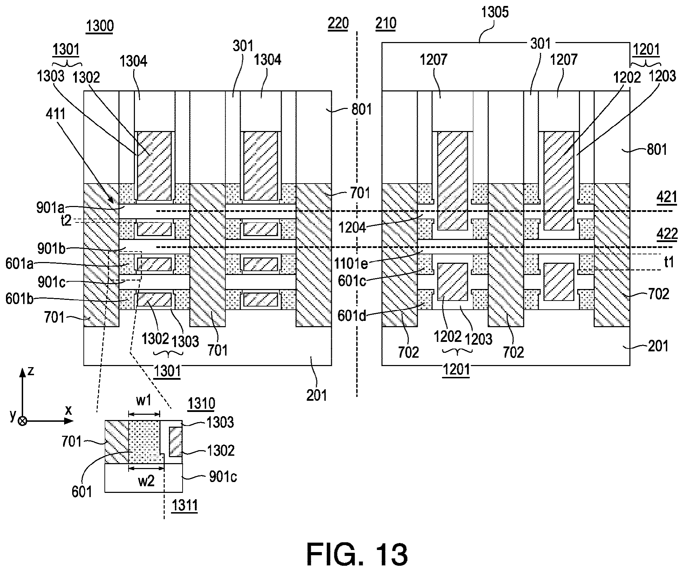

FIG. 13 is a cross-sectional side view of an example IC structure 1300 similar to IC structure 1200, after patterning a mask layer 1305 and after formation of gate structure 1301, which includes a gate dielectric layer 1303 and a gate electrode 1302. Gate structure 1301 may be formed by conformal deposition of gate dielectric layer 1303, conformal deposition of a work function metal of gate electrode 1302, and metal fill of a remainder of gate electrode 1302. Formation of gate structure 1301may include formation of a dielectric material 1304.

As discussed, removal of semiconductor structures enables a thicker gate dielectric layer 1203 for thick gate dielectric transistor structure 210. In contrast, gate dielectric layer 1303 of thin gate dielectric transistor structure 220 has a smaller thickness t2 relative to thickness t1 of gate dielectric layer 1203 of thick gate dielectric transistor structure 210. In some embodiments, thickness t2 is not more than half of thickness t1. In some embodiments, thickness t2 is not more than 75% of thickness t1. In some embodiments, thickness t2 is not more than 40% of thickness t1. In some embodiments, thickness t2 is not more than 25% of thickness t1. Thickness t2 may be any suitable thickness one each of semiconductor structures 901 such as a thickness of not more than 3 nm, not more than 2 nm, or not more than 1 nm. Other thickness may be used. In some embodiments, gate dielectric layer 1303 is or includes aluminum oxide, hafnium oxide, zirconium oxide, titanium silicon oxide, hafnium silicon oxide, silicon oxide, or silicon nitride. For example, gate dielectric layer 1303 may include aluminum and oxygen; hafnium and oxygen; zirconium and oxygen; titanium, silicon, and oxygen; hafnium, silicon, and oxygen; silicon and oxygen; or silicon and nitrogen. In some embodiments, gate electrode 1302 includes a work function layer of platinum, nickel, titanium nitride, or tantalum nitride and a fill metal such as tungsten. However, other material systems may be used. As discussed, in some embodiments, gate dielectric layer 1203 and gate dielectric layer 1303 are different materials. In some embodiments, gate dielectric layer 1203 is silicon oxide (i.e., includes silicon and oxygen) and gate dielectric layer 1303 is one aluminum oxide (i.e., includes aluminum and oxygen), hafnium oxide (i.e., includes hafnium and oxygen), zirconium oxide (i.e., includes zirconium and oxygen), titanium silicon oxide (i.e., includes titanium, silicon, and oxygen), or hafnium silicon oxide (i.e., includes hafnium, silicon, and oxygen).

As shown, thin gate dielectric transistor structure 220 includes any number of semiconductor structures 901 laterally between and coupled to source and drain structures 701. Gate structure 1301 includes gate dielectric layer 1303 (e.g., a gate dielectric) on and surrounding a channel region of each of semiconductor structures 901 and gate electrode 1302 (e.g., a gate metal) surrounding gate dielectric layer 1303. Dielectric spacers 601 such as dielectric spacers 601a, b are laterally between and on gate structure 1301 and one or both of source and drain structures 701. As shown with respect to insert 1310, dielectric spacer 601 is on semiconductor structure 901c adjacent channel region 1311 (i.e., the portion of on semiconductor structure 901c adjacent to and controlled by gate structure 1301). As previously discussed dielectric spacer 601 may have first width w1 and second width w2 each extending between gate structure 1301 and source or drain structure 701 such that the first width w1 is adjacent semiconductor structure 901c (i.e., a semiconductor structure that had cladding) and the second width w2 is distal semiconductor structure 901c and is adjacent semiconductor structure 901b (i.e., a semiconductor structure that did not have cladding cladding). Second width w2 is greater than first width w1, and may widths w1, w2 may have any values or relationships discussed above.

Returning to FIG. 1, processing continues at operation 111, where frontside metal contacts and metallization are formed over the transistor structures. Such contacts may be formed using any suitable technique or techniques such as patterning to form openings in a dielectric material, bulk metal deposition, and CMP processing to remove overburden as is known in the art. For example, frontside contacts may be made to any one or more of the three terminals, source, drain, and gate, of the transistor structure being fabricated. The frontside contacts are then interconnected by metallization layers over the frontside contact. In some embodiments, the gate and drain of the transistor structure are contacted from the frontside to provide signal routing and the source of the transistor structure is contacted from the backside to provide power delivery. However, any interconnect routing may be used. In some embodiments, only frontside contacts and metallization are used.

FIG. 14 is a cross-sectional side view of an example IC structure 1400 similar to IC structure 1300, after the formation of frontside source contact 1401, frontside gate contact 1402, and frontside drain contact 1403 of thin gate dielectric transistor structure 220 and frontside source contact 1404, frontside gate contact 1405, and frontside drain contact 1406 of thick gate dielectric transistor structure 210. Frontside contacts 1401-1406 may be formed using operations known in the art such as lithography patterning of openings or vias, and via metal fill, and optional planarization. Such components may include any suitable materials. For example, frontside contacts 1401-1406 may include a liner material such as titanium nitride and a fill metal such as tungsten. However, other material systems may be used. Over IC structure 1400, frontside metallization layers may be formed using any suitable technique or techniques such as dual damascene techniques, single damascene techniques, subtractive metallization patterning techniques, or the like. Frontside metallization layers are illustrated herein below with respect to FIG. 16. Notably, frontside metallization layers may be formed prior to mounting IC structure 1400 to a carrier wafer and performing backside processing as discussed below.

Returning to FIG. 1, processing continues at operation 112, where optional backside metal contacts for the transistor structures are formed, and the workpiece is further processed and output. In some embodiments, backside metal contacts are made to the source structures of the transistor structure. The backside metal contact may be made using any suitable technique or techniques such as patterning, metal deposition, and CMP processing as is known in the art. The backside contacts are then interconnected by metallization layers over the backside contacts. In some embodiments, the gate and drain of the transistor structures are contacted from the frontside to provide signal routing, and the source of the transistor structures are contacted from the backside to provide power delivery. However, any interconnect routing may be used. Subsequently, metallization layers are formed over the backside contacts additional fabrication processes may be completed, and the resultant structure may be output. Such processing may include backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

FIG. 15 is a cross-sectional side view of an example IC structure 1500 similar to IC structure 1400, after the formation of backside source contacts 1501, 1502 embedded in dielectric layer 1503. Backside source contacts 1501, 1502 may be formed using any suitable technique or techniques such as patterning an opening in dielectric layer 1503, depositing metal, and planarization operations to form backside source contacts 1501, 1502. In some embodiments, backside reveal processing is used to remove substrate 201 and dielectric layer 1503 is formed using bulk deposition techniques. In some embodiments, backside source contacts 1501, 1502 include a liner material such as titanium nitride and a fill metal such as tungsten. However, other materials may be used. As discussed, backside source contacts 1501, 1502 may provide power delivery for thin gate dielectric transistor structure 220 and thick gate dielectric transistor structure 210.

As discussed, processing continues with backside metallization optionally being formed over the backside contacts, additional fabrication processes may be completed, and the resultant structure may be output.

FIG. 16 is a cross-sectional side view of a multi-layer integrated circuit device structure 1600 incorporating thin gate dielectric transistor structure 220 and thick gate dielectric transistor structure 210 of integrated circuit structure 1500, in accordance with at least some embodiments of the present disclosure. Although illustrated and discussed with respect to IC structure 1500 of FIG. 15, any IC structure discussed herein such as IC structure 1400 of FIG. 14 may be deployed in the context of multi-layer integrated circuit device structure 1600. As shown, multi-layer integrated circuit device structure 1600 is incorporated in integrated circuit (IC) die 1607 such that multi-layer integrated circuit device structure 1600 includes frontside metallization layers 1601 (or frontside interconnect layers) and backside metallization layers 1602 (or backside interconnect layers). Frontside metallization layers 1601 and backside metallization layers 1602 may be formed using any suitable technique or techniques such as dual damascene techniques, single damascene techniques, subtractive metallization patterning techniques, or the like.

For example, interconnectivity, signal routing, power-delivery, and the like may be provided by frontside metallization layers 1601. Adjacent metallization layers, such as metallization interconnects 1610, are interconnected by vias, such as vias 1603, that may be characterized as part of the metallization layers or between the metallization layers. As shown, in some embodiments, frontside metallization layers 1601 are formed over and immediately adjacent thin gate dielectric transistor structure 220 and thick gate dielectric transistor structure 210. In the illustrated example, frontside metallization layers 1601 include M0, V0, M1, M2/V1, M3/V2, and M4/V3. However, frontside metallization layers 1601 may include any number of metallization layers such as six, eight, or more metallization layers.

Similarly, backside metallization layers 1602, may be used for interconnectivity, signal routing, power-delivery, and any other suitable electrical connectivity. In some embodiments, frontside metallization layers 1601 are used exclusively for signal routing and backside metallization layers 1602 are used exclusively for power delivery. However, any interconnection architecture may be used. In the illustrated example, package level interconnects 1611 are provided on or over a device backside as bumps over a passivation layer 1605. However, package level interconnects 1611 may be provided using any suitable interconnect structures such as bond pads, solder bumps, etc. As shown, in some embodiments, backside metallization layers 1602 are formed such that a device layer 1604 including thin gate dielectric transistor structure 220 and thick gate dielectric transistor structure 210 is between frontside metallization layers 1601 and backside metallization layers 1602. In the illustrated example, backside metallization layers 1602 include BM0, BM1, and BM2 with intervening via layers. However, backside metallization layers 1602 may include any number of metallization layers such as three, four, or more metallization layers.

In some embodiments, thin gate dielectric transistor structure 220 and thick gate dielectric transistor structure 210 are deployed in a monolithic integrated circuit (IC) die 1607 including gate-all-around field effect transistor structures (e.g., a GAA-FETs) having any of the components and characteristics discussed herein. As shown, a power supply 1606 may be coupled to IC die 1607, such that power supply 1606 may include a battery, voltage converter, power supply circuitry, or the like.

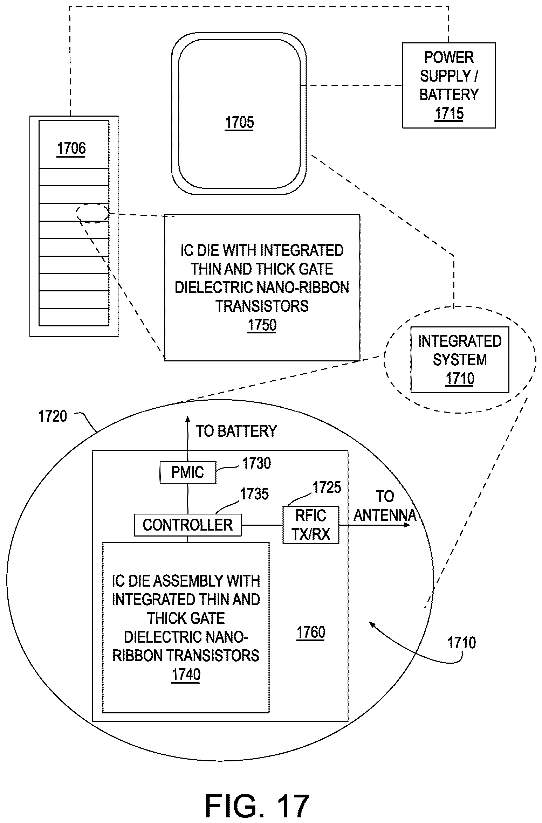

FIG. 17 illustrates exemplary systems employing an integrated circuit assembly including an integrated circuit die having a thin gate dielectric transistor structure integrated with a thick gate dielectric transistor structure, in accordance with some embodiments. The system may be a mobile computing platform 1705 and/or a data server machine 1706, for example. Either may employ a component assembly including an IC die having a thin gate dielectric transistor structure integrated with a thick gate dielectric transistor structure as described elsewhere herein. Server machine 1706 may be any commercial server, for example including any number of high-performance computing platforms disposed within a rack and networked together for electronic data processing, which in the exemplary embodiment includes an IC die assembly 1750 with an IC die having a thin gate dielectric transistor structure integrated with a thick gate dielectric transistor structure as described elsewhere herein. Mobile computing platform 1705 may be any portable device configured for each of electronic data display, electronic data processing, wireless electronic data transmission, or the like. For example, mobile computing platform 1705 may be any of a tablet, a smart phone, a laptop computer, etc., and may include a display screen (e.g., a capacitive, inductive, resistive, or optical touchscreen), a chip-level or package-level integrated system 1710, and a battery 1715. Although illustrated with respect to mobile computing platform 1705, in other examples, chip-level or package-level integrated system 1710 and a battery 1715 may be implemented in a desktop computing platform, an automotive computing platform, an internet of things platform, or the like. As discussed below, in some examples, the disclosed systems may include a sub-system 1760 such as a system on a chip (SOC) or an integrated system of multiple ICs, which is illustrated with respect to mobile computing platform 1705.

Whether disposed within integrated system 1710 illustrated in expanded view 1720 or as a stand-alone packaged device within data server machine 1706, sub-system 1760 may include memory circuitry and/or processor circuitry 1740 (e.g., RAM, a microprocessor, a multi-core microprocessor, graphics processor, etc.), a power management integrated circuit (PMIC) 1730, a controller 1735, and a radio frequency integrated circuit (RFIC) 1725 (e.g., including a wideband RF transmitter and/or receiver (TX/RX)). As shown, one or more IC dies, such as memory circuitry and/or processor circuitry 1740 may be assembled and implemented such that one or more have a thin gate dielectric transistor structure integrated with a thick gate dielectric transistor structure as described herein. In some embodiments, RFIC 1725 includes a digital baseband and an analog front-end module further comprising a power amplifier on a transmit path and a low noise amplifier on a receive path). Functionally, PMIC 1730 may perform battery power regulation, DC-to-DC conversion, etc., and so has an input coupled to battery 1715, and an output providing a current supply to other functional modules. As further illustrated in FIG. 17, in the exemplary embodiment, RFIC 1725 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1740 may provide memory functionality for sub-system 1760, high level control, data processing and the like for sub-system 1760. In alternative implementations, each of the SOC modules may be integrated onto separate ICs coupled to a package substrate, interposer, or board.

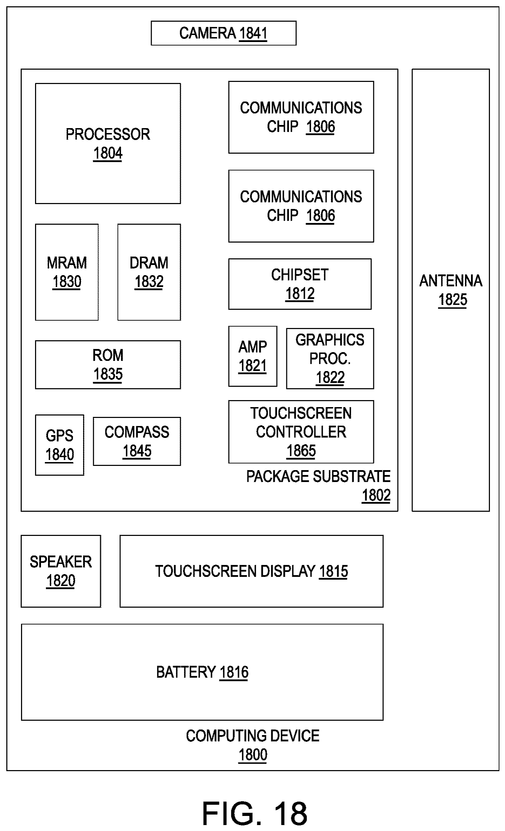

FIG. 18 is a functional block diagram of an electronic computing device 1800, in accordance with some embodiments. For example, device 1800 may, via any suitable component therein, have a thin gate dielectric transistor structure integrated with a thick gate dielectric transistor structure in accordance with any embodiments described elsewhere herein. Device 1800 further includes a motherboard or package substrate 1802 hosting a number of components, such as, but not limited to, a processor 1804 (e.g., an applications processor). Processor 1804 may be physically and/or electrically coupled to package substrate 1802. In some examples, processor 1804 is within an IC assembly that includes an IC die having a thin gate dielectric transistor structure integrated with a thick gate dielectric transistor structure as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1806 may also be physically and/or electrically coupled to the package substrate 1802. In further implementations, communication chips 1806 may be part of processor 1804. Depending on its applications, computing device 1800 may include other components that may or may not be physically and electrically coupled to package substrate 1802. These other components include, but are not limited to, volatile memory (e.g., DRAM 1832), non-volatile memory (e.g., ROM 1835), flash memory (e.g., NAND or NOR), magnetic memory (MRAM 1830), a graphics processor 1822, a digital signal processor, a crypto processor, a chipset 1812, an antenna 1825, touchscreen display 1815, touchscreen controller 1865, battery 1816, audio codec, video codec, power amplifier 1821, global positioning system (GPS) device 1840, compass 1845, accelerometer, gyroscope, speaker 1820, camera 1841, and mass storage device (such as hard disk drive, solid-state drive (SSD), compact disk (CD), digital versatile disk (DVD), and so forth, or the like.

Communication chips 1806 may enable wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1806 may implement any of a number of wireless standards or protocols, including, but not limited to, those described elsewhere herein. As discussed, computing device 1800 may include a plurality of communication chips 1806. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

The following pertains to exemplary embodiments.

In one or more first embodiments, an apparatus comprises at least one semiconductor structure laterally between and coupled to a source structure and a drain structure, a gate structure comprising a gate dielectric on and surrounding a channel region of the semiconductor structure and a gate electrode surrounding the gate dielectric, and a dielectric spacer laterally between and on the gate structure and one of the source structure or the drain structure, the dielectric spacer on the at least one semiconductor structure adjacent the channel region, such that the dielectric spacer has a first width and a second width each extending between the gate structure and the source structure or the drain structure, the first width adjacent the semiconductor structure and the second width distal the semiconductor structure and not less than ten percent greater than the first width.

In one or more second embodiments, further to the first embodiments, a portion of the gate dielectric is on the dielectric spacer and is in contact with source structure or the drain structure.

In one or more third embodiments, further to the first or second embodiments, the dielectric spacer comprises silicon, oxygen, and nitrogen, and the gate dielectric comprises silicon and oxygen.

In one or more fourth embodiments, further to the first through third embodiments, the dielectric spacer is a first dielectric spacer, and a second dielectric spacer is on the portion of the gate dielectric over the first dielectric spacer.

In one or more fifth embodiments, further to the first through fourth embodiments, the semiconductor structure is a first semiconductor structure, and the apparatus further comprises a plurality of vertically aligned second semiconductor structures each laterally between and coupled to a second source structure and a second drain structure, such that a first of the second semiconductor structures is co-planar with the first semiconductor structure and a second of the second semiconductor structures is co-planar with the portion of the gate dielectric.

In one or more sixth embodiments, further to the first through fifth embodiments, the gate dielectric is a first gate dielectric, and the apparatus further comprises a second gate dielectric on the second semiconductor structures, such that the first gate dielectric comprises silicon and oxygen, and the second dielectric comprises oxygen and one of hafnium, aluminum, zirconium, or titanium.

In one or more seventh embodiments, further to the first through sixth embodiments, the first gate dielectric has a first thickness on the channel region and the second dielectric has a second thickness on the second semiconductor structures not more than half the first thickness.

In one or more eighth embodiments, further to the first through seventh embodiments, the second width is not less than 25% greater than the first width.

In one or more ninth embodiments, further to the first through eighth embodiments, the apparatus further comprises an integrated circuit (IC) die comprising the semiconductor structure, the source structure, the drain structure, the gate structure, and the dielectric spacer, and a power supply coupled to the IC die.

In one or more tenth embodiments, a system comprises an IC die according to any of the apparatuses of the first through eighth embodiments, and a display and/or a power supply coupled to the IC die.

In one or more eleventh embodiments, at least one semiconductor structure laterally between and coupled to a source structure and a drain structure, a gate structure comprising a gate dielectric on and surrounding a channel region of the semiconductor structure and a gate electrode surrounding the gate dielectric, and a dielectric spacer laterally between and on the gate structure and one of the source structure or the drain structure, the dielectric spacer on the at least one semiconductor structure adjacent the channel region, such that a portion of the gate dielectric is on the dielectric spacer and is in contact with source structure or the drain structure.

In one or more twelfth embodiments, further to the eleventh embodiments, the dielectric spacer is a first dielectric spacer, and a second dielectric spacer is on the portion of the gate dielectric over the first dielectric spacer.

In one or more thirteenth embodiments, further to the eleventh or twelfth embodiments, the second dielectric spacer has a first width and a second width each extending between the gate structure and the source structure or the drain structure, the first width adjacent the portion of the gate dielectric and the second width distal the portion of the gate dielectric and not less than ten percent less than the first width.

In one or more fourteenth embodiments, further to the eleventh through thirteenth embodiments, the semiconductor structure is a first semiconductor structure, and the apparatus further comprises a plurality of vertically aligned second semiconductor structures each laterally between and coupled to a second source structure and a second drain structure, such that a first of the second semiconductor structures is co-planar with the first semiconductor structure and a second of the second semiconductor structures is co-planar with the portion of the gate dielectric.

In one or more fifteenth embodiments, further to the eleventh through fourteenth embodiments, the gate dielectric is a first gate dielectric, and the apparatus further comprises a second gate dielectric on the second semiconductor structures, such that the first gate dielectric has a first thickness on the channel region and comprises silicon and oxygen, the second dielectric has a second thickness on the second semiconductor structures and comprises oxygen and one of hafnium, aluminum, zirconium, or titanium, and the second thickness is not more than half the first thickness.

In one or more sixteenth embodiments, further to the eleventh through fifteenth embodiments, the dielectric spacer comprises silicon, oxygen, and nitrogen, and the gate dielectric comprises silicon and oxygen.

In one or more seventeenth embodiments, further to the eleventh through sixteenth embodiments, the apparatus further comprises an integrated circuit (IC) die comprising the semiconductor structure, the source structure, the drain structure, the gate structure, and the dielectric spacer, and a power supply coupled to the IC die.

In one or more eighteenth embodiments, a system comprises an IC die according to any of the apparatuses of the eleventh through sixteenth embodiments, and a display and/or a power supply coupled to the IC die.

In one or more nineteenth embodiments, an apparatus comprises a plurality of vertically aligned first nanoribbons each laterally between and coupled to a first source structure and a first drain structure, a first gate structure coupled to each of the first nanoribbons, a plurality of vertically aligned second nanoribbons each laterally between and coupled to a second source structure and a second drain structure, and a second gate structure coupled to each of the first nanoribbons, such that a first nanoribbon of the first nanoribbons is co-planar with a first nanoribbon of the second nanoribbons, and the first nanoribbons have more nanoribbons than the second nanoribbons.

In one or more twentieth embodiments, further to the nineteenth embodiments, the first gate structure comprises a first gate dielectric having a first thickness and the second gate structure comprises a second gate dielectric having a second thickness not less than twice the first thickness.

In one or more twenty-first embodiments, further to the nineteenth or twentieth embodiments, the first gate dielectric comprises oxygen and one of hafnium, aluminum, zirconium, or titanium, and the second gate dielectric comprises silicon and oxygen.

In one or more twenty-second embodiments, further to the nineteenth through twenty-first embodiments, the apparatus further comprises an integrated circuit (IC) die comprising the first nanoribbons, the first source structure, the first drain structure, the first gate structure, the second nanoribbons, the second source structure, the second drain structure, and the second gate structure, and a power supply coupled to the IC die.

In one or more twenty-third embodiments, a system comprises an IC die according to any of the apparatuses of the nineteenth through twenty-first embodiments, and a display and/or a power supply coupled to the IC die.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
at least one semiconductor structure laterally between and coupled to a source structure and a drain structure;
a gate structure comprising a gate dielectric on and surrounding a channel region of the semiconductor structure and a gate electrode surrounding the gate dielectric; and
a dielectric spacer laterally between and on the gate structure and one of the source structure or the drain structure, the dielectric spacer on the at least one semiconductor structure adjacent the channel region, wherein the dielectric spacer has a first width and a second width each extending between the gate structure and the source structure or the drain structure, the first width adjacent the semiconductor structure and the second width distal the semiconductor structure and not less than ten percent greater than the first width.

2. The apparatus of claim 1, wherein a portion of the gate dielectric is on the dielectric spacer and is in contact with source structure or the drain structure.

3. The apparatus of claim 1 or 2, wherein the dielectric spacer comprises silicon, oxygen, and nitrogen, and wherein the gate dielectric comprises silicon and oxygen.

4. The apparatus of any one of claims 1 to 3, wherein the dielectric spacer is a first dielectric spacer, and wherein a second dielectric spacer is on the portion of the gate dielectric over the first dielectric spacer.

5. The apparatus of any one of claims 1 to 4, wherein the semiconductor structure is a first semiconductor structure, the apparatus further comprising:
a plurality of vertically aligned second semiconductor structures each laterally between and coupled to a second source structure and a second drain structure, wherein a first of the second semiconductor structures is co-planar with the first semiconductor structure and wherein a second of the second semiconductor structures is co-planar with the portion of the gate dielectric.

6. The apparatus of claim 5, wherein the gate dielectric is a first gate dielectric, the apparatus further comprising a second gate dielectric on the second semiconductor structures, wherein the first gate dielectric comprises silicon and oxygen, and wherein the second dielectric comprises oxygen and one of hafnium, aluminum, zirconium, or titanium.

7. The apparatus of claim 6, wherein the first gate dielectric has a first thickness on the channel region and the second dielectric has a second thickness on the second semiconductor structures not more than half the first thickness.

8. The apparatus of any one of claims 1 to 7, wherein the second width is not less than 25% greater than the first width.

9. The apparatus of any one of claims 1 to 8, further comprising:
an integrated circuit (IC) die comprising the semiconductor structure, the source structure, the drain structure, the gate structure, and the dielectric spacer; and
a power supply coupled to the IC die.

10. A method, comprising:
forming at least one semiconductor structure laterally between and coupled to a source structure and a drain structure;
forming a gate structure comprising a gate dielectric on and surrounding a channel region of the semiconductor structure and a gate electrode surrounding the gate dielectric; and
forming a dielectric spacer laterally between and on the gate structure and one of the source structure or the drain structure, the dielectric spacer on the at least one semiconductor structure adjacent the channel region, wherein the dielectric spacer has a first width and a second width each extending between the gate structure and the source structure or the drain structure, the first width adjacent the semiconductor structure and the second width distal the semiconductor structure and not less than ten percent greater than the first width.

11. The method of claim 10, wherein a portion of the gate dielectric is on the dielectric spacer and is in contact with source structure or the drain structure, the dielectric spacer comprises silicon, oxygen, and nitrogen, and the gate dielectric comprises silicon and oxygen

12. The method of claim 10 or 11, wherein the semiconductor structure is a first semiconductor structure, the method further comprising:
forming a plurality of vertically aligned second semiconductor structures each laterally between and coupled to a second source structure and a second drain structure, wherein a first of the second semiconductor structures is co-planar with the first semiconductor structure and wherein a second of the second semiconductor structures is co-planar with the portion of the gate dielectric.

13. The method of claim 12, wherein the gate dielectric is a first gate dielectric, the method further comprising:
forming a second gate dielectric on the second semiconductor structures, wherein the first gate dielectric comprises silicon and oxygen, and wherein the second dielectric comprises oxygen and one of hafnium, aluminum, zirconium, or titanium.

14. The method of claim 13, wherein the first gate dielectric has a first thickness on the channel region and the second dielectric has a second thickness on the second semiconductor structures not more than half the first thickness.

15. The method of any one of claims 10 to 14, wherein the second width is not less than 25% greater than the first width.
